# EUROPÄISCHE PATENTANMELDUNG

(11) **EP 3 979 489 A1**
(43) Veröffentlichungstag der Anmeldung: **06.04.2022**
(21) Anmeldenummer: 20199139.5
(22) Anmeldetag: 30.09.2020
(51) Int. Cl.: H02P 21/00, H02P 21/32, H02P 21/14, H02P 9/14, G01R 27/08

(54) **PARAMETERIDENTIFIKATION FÜR DREHFELDMASCHINEN**

(71) Anmelder: Siemens Aktiengesellschaft, 80333 München (DE)
(72) Erfinder: Die Erfindernennung liegt noch nicht vor

(57) **Zusammenfassung**

Die Erfindung betrifft ein Verfahren zur Bestimmung von Parametern zur Regelung eines elektrischen Antriebs (1), wobei der elektrische Antrieb (1) mindestens eine elektrische Maschine (2) aufweist. Zur Verbesserung der Inbetriebsetzung des elektrischen Antriebs wird vorgeschlagen, dass an dreiphasigen Wicklungsanschlüssen (U,V,W) der elektrischen Maschine (2) als Signal ein Stromzeiger angelegt wird, wobei jeweils eine d-Komponente und eine q-Komponente der Statorspannung und des Statorstroms an den Wicklungsanschlüssen (U,V,W) gemessen wird, wobei in einem ersten Messschritt (11) ein rotierender Stromzeiger an die dreiphasigen Wicklungsanschlüsse (U,V,W) angelegt wird und die elektrische Maschine (2) derart ausgerichtet wird, dass ein Erregerstrom in der q-Achse ein Minimum annimmt, wobei in einem zweiten Messschritt bei feststehendem Rotor der elektrischen Maschine (2) eine Feldwicklung (7) der elektrischen Maschine (2) kurzgeschlossen und an die Wicklungsanschlüsse (U,V,W) ein Stromzeiger in Form eines binären Rauschsignals angelegt wird, wobei aus den Messwerten eine Statorimpedanz (Zd) als ein erster Regelparameter bestimmt wird. Ferner betrifft die Erfindung eine Regelvorrichtung (4) für einen elektrischen Antrieb (1), wobei die Regelvorrichtung (4) zur Durchführung eines derartigen Verfahrens eingerichtet ist.

## Beschreibung

Die Erfindung betrifft ein Verfahren zur Bestimmung von Regelparametern zur Regelung eines elektrischen Antriebs mittels einer Vektorregelung, wobei der elektrische Antrieb mindestens eine elektrische Maschine aufweist. Ferner betrifft die Erfindung eine Regelvorrichtung für einen elektrischen Antrieb mittels Vektorregelung sowie einen elektrischen Antrieb mit einer derartigen Regelvorrichtung, einem Frequenzumrichter und einer elektrischen Maschine.

Ein elektrischer Antrieb weist oftmals zumindest einen Frequenzumrichter und eine elektrische Maschine auf. Dabei steuert oder regelt der Frequenzumrichter die elektrische Maschine. Für die Regelung gibt es verschiedene mathematische Ansätze. Ein Ansatz ist die Vektorregelung. Zur Parametrierung der Vektorregelung des Frequenzumrichters werden dabei Parameter der elektrischen Maschine benötigt, die sich oftmals aus der physikalischen Beschreibung, Nachbildung oder Modellierung der elektrischen Maschine ergeben. Die benötigten Daten liegen dabei als Ersatzschaltbilddaten häufig gar nicht, unvollständig oder fehlerhaft vor. Die für die Regelung benötigten Parameter werden auch als Regelparameter bezeichnet.

Derzeit werden die Parameter der elektrischen Maschine, auch als Motorparameter bezeichnet, während der Inbetriebsetzung teilweise sehr zeitaufwendig durch unterschiedliche Herangehensweise und Versuche ermittelt.

Der Erfindung liegt die Aufgabe zugrunde, die Inbetriebsetzung des elektrischen Antriebs zu verbessern.

Diese Aufgabe wird durch ein Verfahren zur Bestimmung von Regelparametern zur Regelung eines elektrischen Antriebs mittels einer Vektorregelung gelöst, wobei der elektrische Antrieb mindestens eine elektrische Maschine aufweist, wobei an dreiphasigen Wicklungsanschlüssen der elektrischen Maschine als Signal ein Stromzeiger angelegt wird, wobei jeweils eine d-Komponente und eine q-Komponente einer Statorspannung und eines Statorstroms an den Wicklungsanschlüssen gemessen wird, wobei in einem ersten Messschritt ein rotierender Stromzeiger an die dreiphasigen Wicklungsanschlüssen angelegt wird und die elektrische Maschine derart ausgerichtet wird, dass ein Erregerstrom in der q-Achse ein Minimum annimmt, wobei in einem zweiten Messschritt bei feststehendem Rotor der elektrischen Maschine eine Feldwicklung der elektrischen Maschine kurzgeschlossen und an die dreiphasigen Wicklungsanschlüsse ein Stromzeiger in Form eines binären Rauschsignals angelegt wird, wobei aus der gemessenen d-Komponente und der q-Komponente der Statorspannung und des Statorstroms eine Statorimpedanz als ein erster Regelparameter bestimmt wird. Ferner wird diese Aufgabe durch eine Regelvorrichtung für einen elektrischen Antrieb zur Durchführung einer Vektorregelung gelöst, wobei die Regelvorrichtung zur Durchführung eines derartigen Verfahrens eingerichtet ist, wobei mittels der Regelvorrichtung in einer Inbetriebsetzungsphase mindestens ein Regelparameter für die Vektorregelung bestimmbar und speicherbar ist, wobei nach Abschluss der Inbetriebsetzungsphase mindestens ein gespeicherter Regelparameter für die Vektorregelung verwendbar ist. Diese Aufgabe wird weiter durch einen elektrischen Antrieb, aufweisend einen Frequenzumrichter und mindestens eine elektrische Maschine gelöst, wobei der Frequenzumrichter eine derartige Regelvorrichtung aufweist, wobei eine Spannungsmessvorrichtung und eine Strommessvorrichtung in der elektrischen Verbindung zwischen Frequenzumrichter und elektrischer Maschine angeordnet sind.

Weitere vorteilhafte Ausgestaltungen der Erfindung sind in den abhängigen Ansprüchen angegeben.

Der Erfindung liegt unter anderem die Erkenntnis zugrunde, dass sich die Inbetriebnahme dadurch verbessern lässt, dass sich in einer Stillstandsmessung beispielsweise mittels der Regelvorrichtung, die Impedanzen in der d-Achse und der q-Achse der elektrischen Maschine ermitteln lassen. Im Folgenden wird die elektrische Maschine auch als Motor bezeichnet. Dazu wird der Rotor der elektrischen Maschine zuerst ausgerichtet und dann festgehalten. Durch die Beaufschlagung der elektrischen Motoranschlüsse mit einem binären Rauschsignal werden dann Statorströme und Statorspannungen an den Anschlussklemmen des Motors gemessen. Mit einem numerischen Verfahren, wie beispielsweise nach Gauß oder Newton werden dann die benötigten Ersatzschaltbilddaten ermittelt. Da diese entsprechenden Werte als Parameter für die Regelung, insbesondere für die Vektorregelung, benötigt werden, werden diese Werte auch als Regelparameter bezeichnet. Diese können unabhängig von der Frequenz der Regelung zur Verfügung gestellt werden oder auch in Abhängigkeit von der Frequenz als sogenannter Frequenzgang ermittelt werden. Durch die Verwendung des Frequenzgangs als Regelparameter kann das Verhalten der Regelung in einzelnen Arbeitspunkten optimiert werden. Gerade beim Vorhandensein von Resonanzstellen kann die Regelung stabilisiert werden und Rückwirkungen auf die Last oder das Energieversorgungsnetz reduziert werden.

Die Messung kann dabei von einer Messvorrichtung, auch als Messbox bezeichnet, durchgeführt werden. Diese Messbox kann mit vergleichsweise niedriger Betriebsspannung von beispielsweise 24V oder 48V betrieben werden. Diese überträgt die ermittelten, berechneten und/oder bestimmten Daten an die Vektorregelung. Dabei kann die Messvorrichtung Teil der Regelvorrichtung sein oder auch außerhalb der Regelvorrichtung angeordnet sein. Auf jeden Fall handelt es sich um eine Messvorrichtung für einen elektrischen Antrieb zur Bestimmung von Regelparametern einer Vektorregelung, wobei die Messvorrichtung zur Durchführung des Verfahrens nach einem der Ansprüche 1 bis 5 eingerichtet ist.

Die elektrische Maschine wird dabei in d- und q-Achse vermessen. Dazu werden die d-Komponente und die q-Komponente von Statorstrom und/oder Statorspannung gemessen. Zur Anregung der Messung wird ein Stromzeiger in Form eines binären Rauschsignals verwendet. Die Positionierung des Stromzeigers erfolgt mittels entspr. Einstellung des Kommutierungswinkels. Es wird jeweils d-Komponente und q-Komponente des Statorstroms und/oder der Statorspannung gemessen. Um weitere Regelparameter zu erhalten kann auch der Strom in der kurzgeschlossenen Feldwicklung gemessen werden. Nach entsprechender Aufbereitung beispielsweise durch eine Fast Fourier Transformation (FFT) der Daten kann ein einzelner Regelparameter oder Frequenzgänge der Statorimpedanz als Regelparameter berechnet werden. Darüber hinaus kann bei Messung in der d-Achse der Frequenzgang des Verhältnisses von Feld- zu Statorstrom als weiterer Regelparameter berechnet werden.

Dann können diese Frequenzgänge auf Basis der bekannten Ersatzschaltbildern in d- und q-Achse ermittelt und mittels geschickter Wahl von Ersatzschaltbildelementen in Widerstände, Induktivitäten und des Windungszahlenverhältnisses zwischen Feld- und Statorwicklung derart überführt werden, dass sich eine möglichst gute Übereinstimmung herstellen lässt. Dazu können bekannte Interpolationsverfahren verwendet werden.

Damit die Messung an definierten Positionen stattfindet, wird in dem ersten Messschritt über ein Minimum im Erregerstrom, die q-Achse detektiert. Der Stromzeiger wird mit einer sehr geringen Frequenz in der Maschine rotiert. Gleichzeitig ist über eine weitere Strommessvorrichtung die Feldwicklung kurzgeschlossen, so dass auch der Feldstrom gemessen werden kann. Das induzierte Signal auf der Feldwicklung erreicht in der q-Achse ein Minimum. Der dazugehörige Transformationswinkel entspricht dann der q-Achse. Der Erregerstrom kann dabei über den Feldstrom oder über den Statorstrom ermittelt werden.

Bei einer vorteilhaften Ausgestaltung der Erfindung wird die Statorimpedanz in Abhängigkeit von der Frequenz mittels einer Fast Fouriertransformation ermittelt wird. Die Fast Fourier Transformation ist eine einfache numerische Auswertung der Messdaten und erlaubt, nicht nur einen einzelnen frequenzunabhängigen Parameter zu generieren, sondern einen Frequenzgang als Regelparameter. Damit können die Arbeitspunkte und das Verhalten der elektrischen Maschine deutlich genauer beschrieben werden. Dadurch kann die elektrische Maschine deutlich einfacher und genauer geregelt werden. Darüber hinaus können auch kritische Arbeitspunkte, beispielsweise aufgrund von Resonanzen genauer beschrieben werden. Der Regelung ist es dann möglich, auch in diesen Arbeitspunkten ein stabiles Regelverhalten zu erzeugen.

Bei einer weiteren vorteilhaften Ausgestaltung der Erfindung wird der Frequenzgang der Statorimpedanz für den Realteil und den Imaginärteil der Statorimpedanz berechnet. Es hat sich als vorteilhaft erwiesen, den komplexen Wert der Impedanz als Real- und Imaginärteil anzugeben. Dadurch ergibt sich ein pyhsikalischer Bezug zu den Größen des Ersatzschaltbildes. Da dieses oftmals die Grundlage und den physikalischen Bezug zu den Regelgrößen bildet, kann die Regelung dadurch besonders einfach aufgebaut werden. Auch können Fehler in der Parameteridentifikation aufgrund von Plausibilitätskontrollen auf einfache Weise ermittelt werden. Somit ergibt sich durch diese Aufteilung eine besonders robuste und wenig fehleranfällige Regelung.

Bei einer weiteren vorteilhaften Ausgestaltung der Erfindung wird der Feldstrom durch die kurzgeschlossene Feldwicklung gemessen, wobei aus Feldstrom und d-Komponente des Statorstroms das Verhältnis von Feldstrom zu Statorstrom als zweiter Regelparameter bestimmt wird. Auf diese Weise können weitere Regelparameter bestimmt werden, welche es erlauben, das Regelverhalten weiter zu verbessern.

Bei einer weiteren vorteilhaften Ausgestaltung der Erfindung werden die ermittelten, berechneten und/oder bestimmten Regelparameter gespeichert für die Verwendung in der Vektorregelung. Durch die Speicherung kann die Ermittlung der Parameter auch außerhalb der Regelvorrichtung durchgeführt werden. Aber auch wenn diese in der Regelvorrichtung ermittelt werden, kann diese Ermittlung über eigene Softwareroutinen durchgeführt werden. Nach Abschluss dieser Ermittlung werden die Daten gespeichert und für die Regelung des Antriebs, insbesondere für die Vektorregelung, verwendet. Die unterschiedlichen Softwareroutinen wie Ermittlung der Regelparameter und Durchführung der Regelung mittels Vektorregelung können dann unabhängig voneinander durchgeführt werden. Dadurch lässt sich die Struktur der Regelvorrichtung optimieren.

Im Folgenden wird die Erfindung anhand der in den Figuren dargestellten Ausführungsbeispiele näher beschrieben und erläutert. Es zeigen:
- FIG 1: einen elektrischen Antrieb,
- FIG 2: ein Ablaufdiagramm und
- FIG 3: den Frequenzgang einer Statorimpedanz.

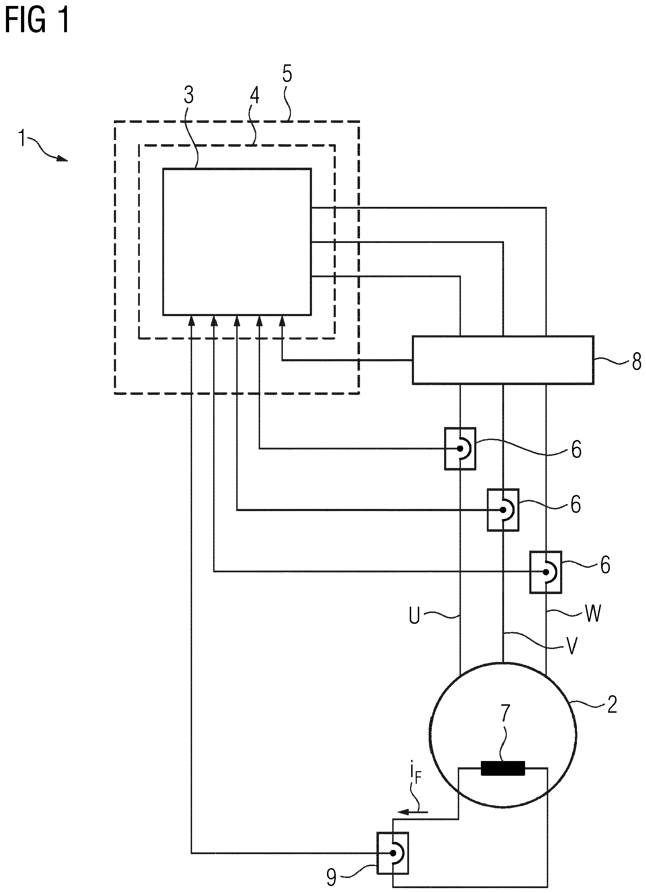

Die FIG 1 zeigt einen elektrischen Antrieb 1 mit einer elektrischen Maschine 2, die über einen Frequenzumrichter 5 mit elektrischer Energie versorgt wird. Der Frequenzumrichter 5 weist dabei eine Regelvorrichtung 4 auf. Diese Regelvorrichtung 4 weist eine Messvorrichtung 3 zur Durchführung des vorgeschlagenen Verfahrens auf. Dabei muss diese Messvorrichtung 3 nicht notwendigerweise Teil des Frequenzumrichters 5 oder Teil der Regelvorrichtung 4 sein. Allerdings bietet es sich an, den Frequenzumrichter 5 als Spannungsquelle für den elektrischen Antrieb 1 zu nutzen, dessen Spannung durch die Messvorrichtung 3 vorgegeben wird. Wicklungsanschlüsse U, V, W sind die Anschlussklemmen der elektrischen Maschine 2. Diese sind mit der Statorwicklung der elektrischen Maschine 2 verbunden. An den Wicklungsanschlüssen U, V, W wird mittels Strommessvorrichtungen 6 der Statorstrom gemessen und mittels einer Spannungsmessvorrichtung 8 die Spannung zwischen den Wicklungsanschlüssen. Dabei ist es hinreichend, nur zwei der drei Spannungen bzw. Ströme zu bestimmen, da sich die dritte Spannung bzw. der dritte Strom aus den beiden anderen mathematisch bestimmen lässt.

Zur Bestimmung der Regelparameter werden die Signale der Strommessvorrichtungen 6 und der Spannungsmessvorrichtung 8 an die Messvorrichtung 3 übertragen.

Darüber hinaus weist die elektrische Maschine 2 noch eine Feldwicklung 7 im Rotor, auch als Rotorwicklung bezeichnet, auf. Mittels einer weiteren Strommessvorrichtung 9 wird die Feldwicklung 7 kurzgeschlossen. Der dabei gemessene Strom kann ebenfalls der Messvorrichtung 3 übermittelt werden. Aus dem Signal der weiteren Strommessvorrichtung 9 kann der Erregerstrom ermittelt werden, mit dem die Ausrichtung der d- und q- Achse erfolgen kann.

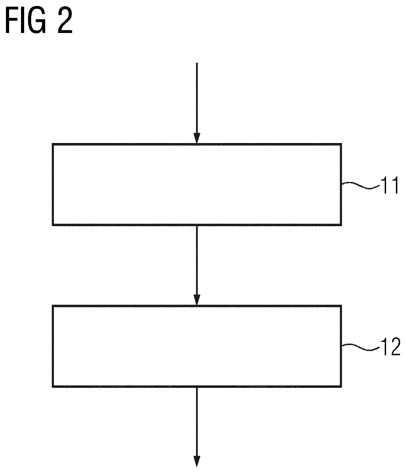

Die FIG 2 zeigt ein Ablaufdiagramm der Parameterbestimmung. In einem ersten Messschritt 11 wird die elektrische Maschine ausgerichtet. Dies bedeutet, dass die Lage der d-Achse und der dazu um 90° versetzten q-Achse bestimmt wird. Dazu wird ein rotierender Stromzeiger in die elektrische Maschine 2 eingespeist, wobei bei einem Minimum des Erregerstroms die q-Achse detektiert wird.

Nachdem die Detektion erfolgreich abgeschlossen wurde wechselt das Verfahren in den zweiten Messschritt 12. Bei diesem werden die Statorströme und die Statorspannungen gemessen und daraus die Statorimpedanz Zd als erster Reglparameter ermittelt. Diese Messungen kann über ein Frequenzbereich erfolgen, so dass sich die Statorimpedanz als Frequenzgang, also in Abhängigkeit für verschiedene Werte der Frequenz, ergibt.

Ist auch dieser zweite Messschritt abgeschlossen, so kann die Regelvorrichtung mit Hilfe dieser Daten die Vektorregelung ausführen und die elektrische Maschine 2 genau steuern und stabil regeln.

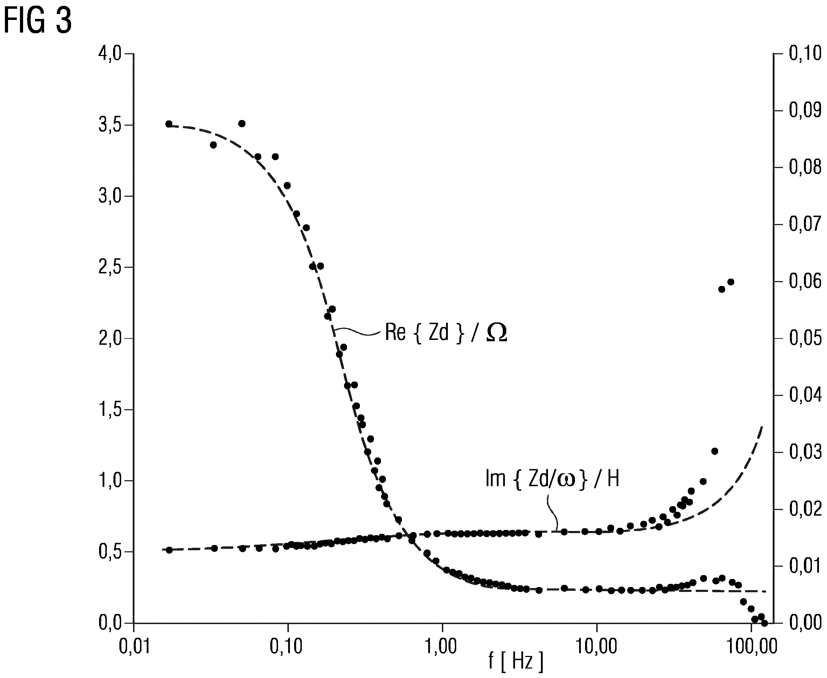

Die FIG 3 zeigt ein typisches Messergebnis der Statorimpedanz, aufgeteilt in Real- und Imaginärteil. Die linke Ordinate gibt dabei die Zahlenwerte für den Realteil an, die rechte Ordinate für den Imaginärteil. Aus diesen Messpunkten kann der Frequenzgang der Statorimpedanz mit bereits bekannten Interpolationsverfahren ermittelt werden.

Zusammenfassend betrifft die Erfindung ein Verfahren zur Bestimmung von Parametern zur Regelung eines elektrischen Antriebs, wobei der elektrische Antrieb mindestens eine elektrische Maschine aufweist. Zur Verbesserung der Inbetriebsetzung des elektrischen Antriebs wird vorgeschlagen, dass an dreiphasigen Wicklungsanschlüssen der elektrischen Maschine als Signal ein Stromzeiger angelegt wird, wobei jeweils eine d-Komponente und eine q-Komponente der Statorspannung und des Statorstroms an den Wicklungsanschlüssen gemessen wird, wobei in einem ersten Messschritt ein rotierender Stromzeiger an die dreiphasigen Wicklungsanschlüsse angelegt wird und die elektrische Maschine derart ausgerichtet wird, dass ein Erregerstrom in der q-Achse ein Minimum annimmt, wobei in einem zweiten Messschritt bei feststehendem Rotor der elektrischen Maschine eine Feldwicklung der elektrischen Maschine kurzgeschlossen und an die Wicklungsanschlüsse ein Stromzeiger in Form eines binären Rauschsignals angelegt wird, wobei aus den Messwerten eine Statorimpedanz als ein erster Regelparameter bestimmt wird. Ferner betrifft die Erfindung eine Regelvorrichtung für einen elektrischen Antrieb, wobei die Regelvorrichtung zur Durchführung eines derartigen Verfahrens eingerichtet ist.

## Patentansprüche

1. Verfahren zur Bestimmung von Regelparametern zur Regelung eines elektrischen Antriebs (1) mittels einer Vektorregelung, wobei der elektrische Antrieb (1) mindestens eine elektrische Maschine (2) aufweist, wobei an dreiphasigen Wicklungsanschlüssen (U,V,W) der elektrischen Maschine (2) als Signal ein Stromzeiger angelegt wird, wobei jeweils eine d-Komponente und eine q-Komponente einer Statorspannung und eines Statorstroms an den Wicklungsanschlüssen (U,V,W) gemessen wird, wobei in einem ersten Messschritt (11) ein rotierender Stromzeiger an die dreiphasigen Wicklungsanschlüssen (U,V,W) angelegt wird und die elektrische Maschine (2) derart ausgerichtet wird, dass ein Erregerstrom in der q-Achse ein Minimum annimmt, wobei in einem zweiten Messschritt bei feststehendem Rotor der elektrischen Maschine (2) eine Feldwicklung (7) der elektrischen Maschine (2) kurzgeschlossen und an die dreiphasigen Wicklungsanschlüsse (U,V,W) ein Stromzeiger in Form eines binären Rauschsignals angelegt wird, wobei aus der gemessenen d-Komponente und der q-Komponente der Statorspannung und des Statorstroms eine Statorimpedanz (Zd) als ein erster Regelparameter bestimmt wird.

2. Verfahren nach Anspruch 1, wobei die Statorimpedanz (Zd) in Abhängigkeit von der Frequenz mittels einer Fast Fouriertransformation ermittelt wird.

3. Verfahren nach Anspruch 2, wobei der Frequenzgang der Statorimpedanz (Zd) für den Realteil und den Imaginärteil der Statorimpedanz (Zd) berechnet wird.

4. Verfahren nach einem der Ansprüche 1 bis 3, wobei ein Feldstrom (i_{F}) durch die kurzgeschlossene Feldwicklung (7) gemessen wird, wobei aus Feldstrom (i_{F}) und d-Komponente des Statorstroms das Verhältnis von Feldstrom (i_{F}) zu Statorstrom als zweiter Regelparameter bestimmt wird.

5. Verfahren nach einem der Ansprüche 1 bis 4, wobei die ermittelten, berechneten und/oder bestimmten Regelparameter gespeichert werden für die Verwendung in der Vektorregelung.

6. Regelvorrichtung (4) für einen elektrischen Antrieb (1) zur Durchführung einer Vektorregelung, wobei die Regelvorrichtung (4) zur Durchführung eines Verfahrens nach einem der Ansprüche 1 bis 5 eingerichtet ist, wobei mittels der Regelvorrichtung (4) in einer Inbetriebsetzungsphase mindestens ein Regelparameter für die Vektorregelung bestimmbar und speicherbar ist, wobei nach Abschluss der Inbetriebsetzungsphase mindestens ein gespeicherter Regelparameter für die Vektorregelung verwendbar ist.

7. Elektrischer Antrieb (1), aufweisend
- einen Frequenzumrichter (5) und
- mindestens eine elektrische Maschine (2),
wobei der Frequenzumrichter (5) eine Regelvorrichtung (4) nach Anspruch 6 aufweist, wobei eine Spannungsmessvorrichtung (8) und eine Strommessvorrichtung (6) in der elektrischen Verbindung zwischen Frequenzumrichter (5) und elektrischer Maschine (2) angeordnet sind.
